# EUROPÄISCHE PATENTSCHRIFT

(11) **EP 1 741 322 B1**
(45) Veröffentlichungstag und Bekanntmachung des Hinweises auf die Patenterteilung: **07.11.2007**
(21) Anmeldenummer: 05716880.9
(22) Anmeldetag: 02.03.2005
(51) Int. Cl.: H05K 1/00, H05K 1/11, H05K 3/40, H05K 3/42

(54) **VERFAHREN ZUR HERSTELLUNG VON LEITERPLATTEN UND/ODER ENTSPRECHENDEN KONSTRUKTEN**
METHOD FOR THE PRODUCTION OF CIRCUIT BOARDS AND/OR CORRESPONDING CONSTRUCTS
PROCEDE POUR PRODUIRE DES CARTES A CIRCUITS IMPRIMES ET/OU DES STRUCTURES EQUIVALENTES

(30) Priorität: 29.04.2004 DE 102004021062
(43) Veröffentlichungstag der Anmeldung: 10.01.2007
(73) Patentinhaber: Siemens Home and Office Communication Devices GmbH & Co. KG, 81541 München (DE)
(72) Erfinder: BUSCH, Georg, 48683 Ahaus (DE)
(86) Internationale Anmeldenummer: PCT/EP2005/050919
(87) Internationale Veröffentlichungsnummer: WO 2005/107342

(56) Entgegenhaltungen:
- WO-A-02/078411
- US-A- 5 001 605
- US-A- 5 487 218
- US-A- 5 758 413

## Beschreibung

Die Erfindung betrifft ein Verfahren zur Herstellung von Leiterplatten und/oder entsprechenden Konstrukten gemäß dem Oberbegriff des Anspruchs 1.

Bei der Herstellung von Leiterplatten und/oder entsprechenden Konstrukten mit Stellen, an denen Durchkontaktierungen realisiert sind, existiert das Problem, dass eine auf das Leiterbahnenbild aufgebrachte Isolierlack-Schicht insbesondere an den Öffnungskanten der Durchgangsbohrungen der Durchkontaktierungen keine sichere Isolierung gewährleistet.

Der Grund hierfür ist zum einen, dass der Isolierlack in die Durchgangsbohrungen läuft und sich an den Öffnungskanten der Durchgangsbohrungen quasi abstreift. Hierdurch wird die Dicke der Isolierlack-Schicht an den betreffenden Kanten zumindest sehr dünn. Zum anderen ist die Isolierlack-Schicht nicht zu 100% porendicht, so dass es kleine und kleinste Löcher gibt, die den elektrischen Widerstand in bezug auf die darunter angeordnete elektrisch leitende Schicht, die in diesem Fall die elektrische Durchkontaktierung bildet, kleiner als Unendlich werden lassen.

Dies wirkt sich zum Beispiel dann nachteilig aus, wenn oberhalb der Durchkontaktierung eine weitere elektrisch leitende Schicht, sei es in Form zum Beispiel einer weiteren Leiterbahn oder in Form zum Beispiel einer größeren Fläche, angeordnet wird. Der Vorteil, der hier erzielt wird, ist, dass die Oberfläche der Leiterplatte oder eines entsprechenden Konstrukts wesentlich intensiver genutzt wird. Es werden nämlich auch diejenigen Bereiche verwendet, die ansonsten frei gelassen werden, um Kurzschlüsse zu den Durchkontaktierungen sicher zu verhindern.

Bei den Kurzschlüssen muss es sich dabei nicht zwangsläufig jeweils um extrem niederohmige Kurzschlüsse handeln. Kurzschlüsse sind auch dann vorhanden, wenn der Isolationswiderstand kleiner Unendlich wird, so dass die Möglichkeit besteht, dass Kriechströme fließen.

Aus dem Dokument WO 02/078411 A ist ein Verfahren zur Herstellung von Leiterplatten mit Stellen bekannt, an denen Durchkontaktierungen realisiert sind, zumindest in deren Nähe weiter Leiterbahnen oder eine elektrisch leitende Schicht vorgesehen ist. Dabei weisen die Durchgangsbohrungen der Durchkontaktierungen Durchmesser auf, die oberhalb eines Größenbereichs von 20 Mikrometer sind. Weiter fehlt ein Verfahrensschritt, in dem das Durchkontaktieren dadurch erfolgt, dass eine elektrisch leitende Gesamtschicht aufgebaut wird, bevor die Durchgänge mit einem Standardmittel gefüllt werden.

Aus dem Dokument US-A-5 758 413 ist ein Verfahren zur Herstellung von Mehrlagenleiterplatten bekannt mit nur für die Durchkontaktierungen einen Durchmesser von 120 Mikrometer und weniger.

Aufgabe der vorliegenden Erfindung ist es, ein einfaches und kostengünstiges Verfahren zur Herstellung von Leiterplatten und/oder entsprechenden Konstrukten mit Stellen, an denen Durchkontaktierungen realisiert sind, zumindest in deren Nähe weiter Leiterbahnen oder Ähnliches vorgesehen sind, anzugeben.

Diese Aufgabe wird erfindungsgemäß durch ein Verfahren gelöst, das die im Anspruch 1 angegebenen Verfahrensschritte aufweist.

Dieses Verfahren hat den Vorteil, dass es einfach in der Abwicklung ist und dass trotzdem sichergestellt ist, dass keine Kurzschlüsse zwischen den Durchkontaktierungen und den zumindest in der Nähe der Durchkontaktierungen angeordneten Leiterbahnen oder dementsprechend Ähnlichen fabriziert sind.

Das Verfahren ist einfach in der Abwicklung und es ist kostengünstig, weil insbesondere ein sehr aufwendiger Bürst-Verfahrensschritt, in dem die Oberfläche der Leiterplatte oder eines entsprechenden Konstrukts gebürstet wird, eingespart wird. Das Verfahren ist auch deshalb einfach und kostengünstig, weil durchwegs Standardmittel verwendbar sind und es somit nicht notwendig ist, Spezialmittel zumindest bei manchen Verfahrensschritten zu verwenden. Das Verfahren gewährleistet die Kurzschlusssicherheit insbesondere auch oberhalb der Durchkontaktierungen, weil oberhalb der Durchkontaktierungen praktisch drei Isolierschichten aufgebracht sind. Erstens ist damit eine insgesamt relativ dicke Gesamtisolierschicht realisiert und ist zweitens die Wahrscheinlichkeit, dass bei drei Isolierschichten dreimal eine offene Pore der jeweiligen Isolierschicht jeweils genau aufeinander trifft, praktisch ausgeschlossen.

Vorteilhafte Ausgestaltungen der Erfindung sind Gegenstand von Unteransprüchen.

Danach können identische Standardmittel in mehreren Verfahrensschritten eingesetzt werden, in denen vormals wenigstens zum Teil Spezialmittel erforderlich waren.

Ein weiterer Vorteil ist, dass die Standartmittel kostengünstige Mittel sein können.

Ein weiterer Vorteil ist, dass die oberhalb der Durchkontaktierungen angeordneten Leiterbahnen oder dergleichen mit kostengünstigem Karbon realisiert sein können.

Schließlich ist es vorteilhaft, dass die Vereinzelung der Leiterplatten oder der entsprechenden Konstrukten nach wie vor durch einfaches Fräsen aus einem größeren Gebilde heraus erfolgen kann.

Nachfolgend wird ein Ausführungsbeispiel der Erfindung anhand einer Zeichnung näher erläutert.

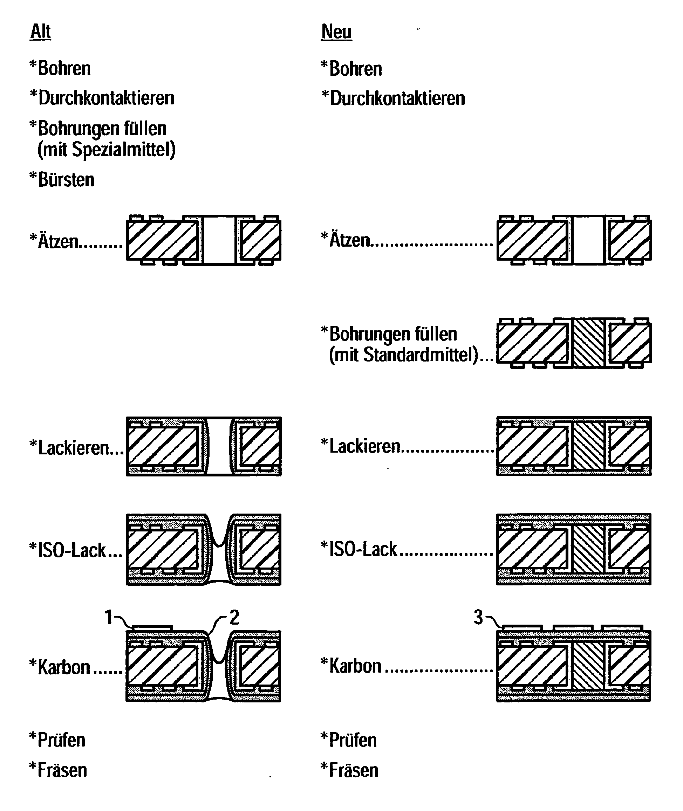

In der einzigen Figur sind auf der linken Seite die Abläufe eines bisherigen Verfahrens und auf der rechten Seite die Abläufe des erfindungsgemäßen Verfahrens zur Herstellung von Leiterplatten und/oder entsprechenden Konstrukten mit Stellen, an denen Durchkontaktierungen im Größenbereich von 20 µm realisiert sind, in deren Nähe bzw. oberhalb derer weitere Leiterbahnen oder Entsprechendes angeordnet sind, einander gegenübergestellt.

Das bisherige Verfahren weist am Beispiel der Herstellung einer Leiterplatte folgende Verfahrensschritte auf:
1. Bohren der Durchgangsbohrungen für die Durchkontaktierungen;
2. Herstellen der Durchkontaktierungen;
3. Füllen der Bohrungen der Durchkontaktierungen mit einer ätzbeständigen Plugging-Paste (= ein Spezialmittel);
4. Bürsten der Oberflächen, damit es möglich wird, nachfolgend auf planen und sauberen Flächen das Ätzbild (Leiterbahnenbild) zu erzeugen;
5. Ätzen der Leiterplatte, worunter alle Maßnahmen zu verstehen sind, die notwendig sind, dass ein fertiges Leiterbahnenbild erzeugt ist;
6. Lackieren der Oberflächen mit einem Stopplack, so dass eine erste Lackschicht aufgebracht ist, die wenigstens geringfügig die elektrisch leitenden Flächen und Flächenteile (Leiterbahnen) bedeckt und auch die Oberflächen der Durchkontaktierungen und weiter die Zwischenräume zwischen den elektrisch leitenden Flächenteilen wenigstens zum Teil verfüllt;
7. Aufbringen des eigentlichen Isolierlacks (ISO-Lack), so dass insgesamt erstens wieder eine plane Oberfläche gegeben ist und zweitens eine sichere Isolierung in bezug auf die darunter angeordneten elektrisch leitenden Flächen und Flächenteile besteht, weshalb es dann möglich ist, dass auf diesen Oberflächen weitere elektrisch leitende Flächen und Flächenteile vorsehbar sind mit Ausnahme oberhalb der Durchkontaktierungen, weil dort letztlich durch das Fehlen einer Verfüllung der Durchkontaktierungen doch keine plane Oberfläche entsteht. Hier läuft jedesmal der Lack zumindest etwas in die Durchkontaktierung hinein;
8. Aufbringen von weiteren elektrisch leitenden Flächen und Flächenteilen (zum Beispiel Karbon-Leiterbahnen (1)), wobei aus Gründen der Vermeidung von Kürzschlüssen insbesondere an den Randkanten (2) der Durchgangsbohrungen der Durchkontaktierungen, an denen sich nur eine besonders dünne Isolierung ausbildet, ein relativ großer Abstand eingehalten wird;
9. Prüfen der Leiterplatte, und
10. Vereinzeln der Leiterplatte durch Herausfräsen der Leiterplatte aus einem Verbund von Leiterplatten, in dem eine Leiterplatte aus Gründen der Wirtschaftlichkeit in der Regel hergestellt wird.

Demgegenüber weist das erfindungsgemäße Verfahren am Beispiel der Herstellung einer Leiterplatte folgende Verfahrensschritte auf:
1. Bohren der Durchgangsbohrungen für die Durchkontaktierungen;
2. Herstellen der Durchkontaktierungen;
3. Ätzen der Leiterplatte, worunter alle Maßnahmen zu verstehen sind, die notwendig sind, dass ein fertiges Leiterbahnenbild erzeugt ist;
4. Füllen der Bohrungen der Durchkontaktierungen mit einer Standard-Plugging-Paste (= Standardmittel in Form einer einen Einspareffekt erzielenden und den Verfahrensablauf vereinfachenden kostengünstigen Lackvariante), wobei an dieser Stelle auf ein aufwendiges und teures Bürsten der Oberflächen verzichtet werden kann (dies ergibt zusammen mit dem Weglassen des aufwendigen und teuren Bürstens der Oberflächen vor dem Ätzen, wie das beim vormaligen Verfahrensablauf ansonsten notwendig war, einen weiteren wesentlichen Einsparungseffekt und eine weitere Vereinfachung des Verfahrensablaufs);
5. Lackieren der Oberflächen mit einem Stopplack, so dass eine erste Lackschicht aufgebracht ist, die wenigstens geringfügig die elektrisch leitenden Flächen und Flächenteile (Leiterbahnen) bedeckt und auch die Zwischenräume zwischen den elektrisch leitenden Flächenteilen wenigstens zum Teil verfüllt;
6. Aufbringen des eigentlichen Isolierlacks (ISO-Lack), so dass insgesamt erstens wieder eine plane Oberfläche gegeben ist und zweitens eine sichere Isolierung in bezug auf die darunter angeordneten elektrisch leitenden Flächen und Flächenteile besteht, weshalb es dann möglich ist, dass auf diesen Oberflächen weitere elektrisch leitende Flächen und Flächenteile vorsehbar sind, und zwar auch direkt oberhalb der Durchkontaktierungen;
7. Aufbringen von weiteren elektrisch leitenden Flächen und Flächenteilen (zum Beispiel Karbon-Leiterbahnen (3)), wobei diese elektrisch leitenden Flächen und Flächenteile jetzt auch mindestens bis zu den Durchkontaktierungen und sogar direkt darüber hinweg geführt sein können;
8. Prüfen der Leiterplatte, und
9. Vereinzeln der Leiterplatte durch Herausfräsen der Leiterplatte aus einem Verbund von Leiterplatten, in dem eine Leiterplatte aus Gründen der Wirtschaftlichkeit in der Regel hergestellt wird.

Die Standard-Plugging-Paste, der Stopplack und der Isolierlack können jeweils identisch sein, das heißt aus eben einer einzigen kostengünstigen Lackvariante bestehen.

Das Aufbringen der Lackschichten kann mittels des an sich bekannten und einfach zu realisierenden Siebdruckverfahrens bewerkstelligt werden.

## Patentansprüche

1. Verfahren zur Herstellung von Leiterplatten und/oder entsprechenden Konstrukten mit Stellen, an denen Durchkontaktierungen im Größenbereich von 20µm realisiert sind, zumindest in deren Nähe weiter Leiterbahnen oder eine elektrisch leitende Schicht vorgesehen sind, **gekennzeichnet durch** folgende wesentlichen Verfahrensschritte:
- Bohren von im Größenbereich von 20 µm liegenden Durchgangsbohrungen für die nachfolgende Herstellung der Durchkontaktierungen;
- Durchkontaktieren, indem eine elektrisch leitende Gesamtschicht aufgebaut wird;
- Ätzen des Leiterbahnenbildes in die elektrisch leitende Gesamtschicht;
- Bohrungen der Durchgänge füllen mit einem Standardmittel;
- Lackieren der Oberflächen, auf denen Durchkontaktierungen vorhanden sind, zumindest in deren Nähe später Leiterbahnen vorgesehen sind;
- Isolierlack (ISO-Lack), welcher ein Standardmittel ist, aufbringen auf die Oberflächen der Leiterplatte und/oder des entsprechenden Konstrukts;
- Herstellen von oberhalb der Durchkontaktierungen angeordneten Leiterbahnen;
- Prüfen der Leiterplatte bzw. des entsprechenden Konstrukts;
- Vereinzeln der Leiterplatte bzw. des entsprechenden Konstrukts.

2. Verfahren nach Anspruch 1, **dadurch gekennzeichnet, dass** die Standardmittel in den verschiedenen Verfahrensschritten jeweils identisch sind;

3. Verfahren nach Anspruch 1 oder 2, **dadurch gekennzeichnet, dass** die Standardmittel in den verschiedenen Verfahrensschritten jeweils kostengünstige Lackvarianten sind.

4. Verfahren nach einem der vorherigen Ansprüche, **dadurch gekennzeichnet, dass** zumindest die oberhalb der Durchkontaktierungen angeordneten Leiterbahnen mit Karbon (3) realisiert sind.

5. Verfahren nach einem der vorherigen Ansprüche, **dadurch gekennzeichnet, dass** das Vereinzeln der Leiterplatten bzw. der entsprechenden Konstrukte durch einen Fräsvorgang bewerkstelligt ist.

## Claims

1. Method for the production of circuit boards and/or corresponding constructs comprising points at which through-connections in the 20 µm size range are created and, at least in the proximity of said points, strip conductors or an electrically conductive layer are also provided, **characterised by** the following key method steps:
- drilling of through-bores in the 20 µm size range for the subsequent production of through-connections;
- through-connecting, whereby an electrically conductive general layer is built up;
- etching of the strip conductor image into the electrically conductive general layer;
- filling of the bores of the through-connections with a standard medium;
- lacquering of the surfaces on which through-connections are present and, at least in the proximity of which, strip conductors are later provided;
- applying of insulating lacquer (ISO lacquer), which is a standard medium, to the surfaces of the circuit board and/or of the corresponding construct;
- producing of strip conductors arranged above the through-connections;
- testing of the circuit board and/or of the corresponding construct;
- separating of the individual circuit board and/or of the corresponding construct.

2. Method according to claim 1, **characterised in that** the standard medium is identical in each of the different method steps.

3. Method according to claim 1 or claim 2, **characterised in that** the standard medium in the different method steps is in each case a low-cost lacquer variant.

4. Method according to any one of the preceding claims, **characterised in that** at least the strip conductors arranged above the through-connections are realised with carbon (3).

5. Method according to any one of the preceding claims, **characterised in that** the separation of the individual circuit boards and/or of the corresponding constructs is accomplished by means of a milling process.

## Revendications

1. Procédé pour produire des cartes à circuits imprimés et/ou des structures correspondantes comprenant des points au niveau desquels sont réalisées des interconnexions d'un ordre de grandeur de 20 µm au moins à proximité desquelles sont encore prévues des pistes conductrices ou une couche électroconductrice, **caractérisé par** les étapes de procédé principales suivantes :
- perçage de trous traversants d'un ordre de grandeur de 20 µm pour la production subséquente des interconnexions;
- interconnexion par la formation d'une couche d'ensemble électroconductrice ;
- gravure du tracé des pistes conductrices dans la couche d'ensemble électroconductrice ;
- remplissage des trous des traversées avec un moyen standard ;
- vernissage des surfaces sur lesquelles sont présentes des interconnexions au moins à proximité desquelles des pistes conductrices sont prévues ultérieurement ;
- application d'un vernis isolant (vernis ISO), qui est un moyen standard, sur les surfaces de la carte à circuit imprimé et/ou de la structure correspondante;
- fabrication de pistes conductrices situées au-dessus des interconnexions;
- test de la carte à circuit imprimé resp. de la structure correspondante;
- individualisation de la carte à circuit imprimé resp. de la structure correspondante.

2. Procédé selon la revendication 1, **caractérisé en ce que** les moyens standards sont à chaque fois identiques dans les différentes étapes de procédé.

3. Procédé selon la revendication 1 ou 2, **caractérisé en ce que** les moyens standards dans les différentes étapes de procédé sont à chaque fois des variantes de vernis bon marché.

4. Procédé selon l'une des revendications précédentes, **caractérisé en ce qu'**au moins les pistes conductrices situées au-dessus des interconnexions sont exécutées en carbone (3).

5. Procédé selon l'une des revendications précédentes, **caractérisé en ce que** l'individualisation des cartes à circuits imprimés resp. des structures correspondantes est réalisée grâce à une opération de fraisage.
